(19) Europäisches Patentamt
European Patent Office
Office européen des brevets

(11) EP 1 932 183 B1

(12) **EUROPEAN PATENT SPECIFICATION**

(45) Date of publication and mention of the grant of the patent:
**16.07.2014 Bulletin 2014/29**

(21) Application number: **06811242.4**

(22) Date of filing: **28.09.2006**

(51) Int Cl.:
***H01L 29/786*** *(2006.01)* ***H01L 51/05*** *(2006.01)*
***H01L 51/30*** *(2006.01)*

(86) International application number:
**PCT/JP2006/319904**

(87) International publication number:
**WO 2007/043419 (19.04.2007 Gazette 2007/16)**

(54) **TRANSISTOR ELEMENT AND MANUFACTURING METHOD**

TRANSISTORELEMENT UND HERSTELLUNGSVERFAHREN

ELEMENTS DE TRANSISTOR ET PROCEDE DE FABRICATION

(84) Designated Contracting States:
**DE FR GB IT NL**

(30) Priority: **03.10.2005 JP 2005290129**

(43) Date of publication of application:
**18.06.2008 Bulletin 2008/25**

(73) Proprietor: **Ricoh Company, Ltd.**
**Tokyo 143-8555 (JP)**

(72) Inventors:
- **ARAUMI, Mayuka**
  **Tokyo 1450072 (JP)**
- **KAWASHIMA, Ikue**
  **Yokohama-shi, Kanagawa 2240006 (JP)**
- **MURAKAMI, Akishige**
  **Yokohama-shi, Kanagawa 2240012 (JP)**
- **YAMAGA, Takumi**
  **Yokohama-shi, Kanagawa 2250014 (JP)**

(74) Representative: **Meissner, Bolte & Partner GbR**
**Anwaltssozietät GbR**
**Widenmayerstrasse 47**
**80538 München (DE)**

(56) References cited:
**DE-A1- 10 340 641**
**JP-A- 2003 324 202**
**US-A1- 2003 067 458**
**US-B1- 6 586 791**
**US-B1- 6 618 029**

- **CHEN FANG-CHUNG ET AL: "Organic thin-film transistors with nanocomposite dielectric gate insulator" APPLIED PHYSICS LETTERS, AIP, AMERICAN INSTITUTE OF PHYSICS, MELVILLE, NY, US LNKD- DOI:10.1063/1.1806283, vol. 85, no. 15, 1 January 2004 (2004-01-01), pages 3295-3297, XP012062938 ISSN: 0003-6951**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 932 183 B1

## Description

### TECHNICAL FIELD

The invention generally relates to a transistor element. Especially, the invention relates to an element structure for stable driving of the transistor element having an upper electrode connected to an organic semiconductor via an insulating film between layers.

### BACKGROUND ART

Instead of inorganic materials like a silicon single crystal and amorphous silicon used for conventional transistors, development of transistors using organic semiconductor materials has been progressing recently. Compared with the case using inorganic materials, the transistor using organic semiconductors has a merit of low cost due to its simple and easy method of manufacture and possibility of layering large areas at low temperature. Because the formation of flexible plastic substrates is possible due to the flexibility of organic materials, as for the transistor using organic semiconductors, applied development has been expected such as a drive element of various electronic devices including display devices.

In the case of using transistors using an organic semiconductor layer arranged in a two-dimensional array as an active matrix substrate for driving a display device and so on, for example, it is needed to form a structure provided with the upper electrode electrically connected to the organic semiconductor layer via an insulating film between layers. As the insulating film between layers, conventionally, methods to form inorganic materials like silicon oxide and silicon nitride with a sputtering method and CVD (chemical vapor deposition) are used. However, there is a problem in that there are lots of steps in these vacuum processes and a transistor characteristic deteriorates due to the formation of through holes.

Also, for the transistor element having the structure shown in figure 1, there is a problem of an increasing OFF-current due to placing the insulating film between layers as a gate insulating film and forming an unnecessary channel- in the organic semiconductor layer because the upper electrode is placed on the opposite side of organic semiconductors sandwiching the insulating film between layers. For example, the result of manufacturing a QVGA electrophoretic display device on a flexible substrate using organic transistors is reported (See non-patent document 1). In the case of positive voltage of a gate voltage, the OFF-current is increased by changing from positive to negative the electrical current potential of pixel electrodes. It is disclosed in non-patent document 1 that a second channel is induced in organic semiconductors due to influence of pixel electrodes even though capacitance of the insulating film between layers which comprises transistor elements, is around 1/20 of the gate insulating film, but there is no solution for it.

On the other hand, a lot of organic transistor elements of structure as shown above are disclosed, but most are related to improvement of the gate insulating film. Among them, about insulating film (the insulating film between layers) provided in a side without the gate insulating film for the active layer, for example, materials including an aromatic compound and/or aromatic ring component polymer are used as the insulating film between layers. By this, low cost by a solution process is realized and the organic field effect transistor which can improve a mobility of an organic transistor is disclosed (for example, see patent document 1.). However, there is no description about the forming of through-holes and the upper electrode, so it does not solve the above problem.

Disclosed is a technique to provide a transistor in which a leak current is restrained and works stably by providing an unevenness which is 5 nm or above and not more than 40 nm on an interface of the insulating film between layers and a semiconductor film (For example, see patent document 2). This technology makes unevenness' by using hydrogen plasma for forming the insulating film between layers comprising inorganic materials; thereupon, a polysilicon active layer is formed.

Also disclosed is technology to provide the organic thin-film transistor in which more current is controlled and that can be carried away by a double gate structure having a pair of a gate insulating film and a gate electrode on above and below the active layer comprising the organic semiconductor layer.(For example, see patent document 3) In a transistor of such a structure, by applying the control voltage that is synchronized to an upper part gate electrode and a lower part gate electrode, much current can be carried so that a channel is formed in top and bottom gate electrode neighborhoods in the active layer, respectively. This technology utilizes the fact that plural channels are formed in the active layer; on the other hand, when each gate voltage in the transistor of a double gate structure cannot be controlled adequately, it is suggested that an unnecessary channel would be formed as described in non-patent document 1.

Also, a structure of a thin-layered transistor is disclosed, in which a TFT of an electro-optics device includes the upper part shading layer and the bottom shading layer and anti-light performance and display quality are improved by placing a channel area in a crossover region of a data Line and a scanning line. (For example, see patent document 4) Also, a semiconductor device is disclosed, in which the semiconductor device includes a gate electrode, gate insulating film and source/drain electrode formed sequentially on the substrate; an organic semiconductor filling in between source/drain electrodes; and an insulating film formed so as to contact surfaces of source/drain electrodes thereon. (For

example, see patent document 5)

Patent Document 1: JP 2005-101555,A
Patent Document 2: JP 2004-247434,A
Patent Document 3: JP 2005-079549,A
Patent Document 4: JP 2004-126557,A
Patent Document 5: JP 2005-223049,A
Non-Patent Document 1: SID 05 DIGEST 3.1: Invited Paper: Rollable QVGA Active-Matrix Displays Based on Organic Electronics, G.H. Gelinck, H.E. Huitema, M. van Mil, E. van Veenendaal, P.J.G. van Lieshout and F.J. Touwslager, Polymer Vision/Philips Research Laboratories, Eindhoven, The Netherlands

DE 10340641 A1 describes an organic field-effect transistor in which an upper electrode contacts the transistor through a through hole via an isolator layer.

US 2003/067458 A1 relates to an active matrix type display device comprising a thin film transistor. This document describes an embodiment wherein the transistor is contacted by an anode via a connector through a gate insulating layer and an interlayer insulation film.

US 6618029 B1 describes a display apparatus comprising a transistor wherein an electrode is connected to the transistor via a contact hole through a gate insulating layer and an interlayer insulation film.

## DISCLOSURE OF THE INVENTION

In a structure of the transistor element shown in figure 1, by placing the upper electrode on the other side sandwiching the insulating film between layers against the organic semiconductor layer, by a case, the voltage will be applied to the upper electrode when source/drain voltage is applied. As a result, as described above, it would be a problem that unnecessary channels are formed in organic semiconductor layers by operating the upper electrode as the gate electrode and operating the insulating film between layers as the gate insulating film. When the channel is formed in organic semiconductor layers at off-state of the transistor, an ON/OFF ratio decreases by increasing the OFF-current and transistor characteristics deteriorate. Thereby, it becomes a serious problem. As a solution to this, it is assumed that an insulating film between layers which is hard to act as the gate insulating layer is formed. That is, as opposed to a requirement for the gate insulating film to have superior performance, it is thought that the dielectric constant should be low, thickness should be large, and an interface with the organic semiconductor layer should not be flat. However, realistically, there has not been a method to form the insulating film between layers satisfying such conditions with a through hole and without causing transistor damage.

It is a general object of the present invention to solve the above described problems. That is, it is a general object of the present invention to provide a transistor element provided with the insulating film between layers not damaging the transistor by a formation process and without forming unnecessary channels in organic semiconductors. A more specific object of the present invention is to provide transistor elements, in which it is difficult to form unnecessary channels in organic semiconductors, with a simple manufacturing method not degrading transistor characteristics by using a insulating film between layers consisting of a mixture of organic materials and particles. Also, it is a general object of the present invention to provide display device using said transistor elements and a manufacturing method of the same.

As a result, for elements that a transistor using an organic semiconductor layer on a substrate, an insulating film between layers contacting the organic semiconductor layer and an upper electrode electrically contacting the transistor via a through hole provided in the insulating film between layers are layered, by using the insulating film between layers consisting of a mixture of organic materials and particles, transistor elements which can achieve the above purpose are obtained, then the present invention is completed.

In order to achieve the above-mentioned object, there is provided according to one aspect of the present invention an organic transistor element comprising a transistor comprising a gate electrode, a gate insulating film and source/drain electrodes formed sequentially on a substrate, and an organic semiconductor filled in between source and drain electrode; an insulating film between layers contacting the organic semiconductor; and an upper electrode on the insulating film between layers, the upper electrode electrically contacting the transistor via a through hole provided in the insulating film between layers, wherein the insulating film between layers comprises inorganic particles dispersed in organic material.

According to the present invention, an unnecessary channel is hard to be formed in the organic semiconductor layer and it is possible to obtain transistor elements which have a superior ON/OFF ratio. Also, by using the transistor elements combined with picture display elements selected from a group comprising liquid crystal display elements, electrophoretic display elements and organic electroluminescence display elements, a display device which has good performance, is thin and lightweight, places few burdens on human eyes, and is a flat-panel type or flexible can be

provided.

Other objects, features and advantages of the present invention will become more apparent from the following detailed description.

BRIEF DESCRIPTION OF THE DRAWINGS

FIGS.1 is a basic structure showing the organic transistor element;
FIGS.2 is a diagram showing the distribution of particle diameter of inorganic particles;
FIG.3 is a diagram showing Cr of the transistor, in which $C_I$ is changed by changing a film thickness of the insulating film between layers and a relative dielectric constant of the transistor element of the present invention, and its ON/OFF ratio;
FIG.4 is diagram showing a structure of the transistor element of the present invention, where (A) is its cross-sectional view and (B) is its plan view;
FIG.5 is a diagram showing the channel forming part of the present invention;
FIG.6 is a diagram showing the display device of the present invention;
FIG.7 is a diagram showing an evaluation result of transistor performance of example 1;
FIG.8 is a diagram showing an evaluation result of transistor performance of comparative example 1; and
FIG.9 is a diagram showing an evaluation result of transistor performance of example 2.

BEST MODE FOR CARRYING OUT THE INVENTION

Next, a description is given, with reference to the accompanying drawings, of an embodiment of the present invention.

The present invention comprises a layered transistor element with a transistor using an organic semiconductor layer on a substrate, an insulating film between layers contacting the organic semiconductor layer, an upper electrode electrically contacting the transistor via a through hole provided in the insulating film between layers, wherein the insulating film between layers consists of a mixture of organic materials and particles, an unnecessary channel is hard to be formed in the organic semiconductor layer, and it is possible for the transistor element to have a superior ON/OFF ratio.

First of all, a structure of the insulating film between layers comprising mixture of the insulating film between layers with organic materials and particles is described.

Particles included in the mixture which comprises the insulating film between layers of the transistor element of the present invention are inorganic particles which can exist as particles after forming the insulating film between layers. Realistically, it is preferable to use inorganic particles which have controllable grain size and are not dissolved but scattered in a medium. In the below, the present invention is described using inorganic particles as the particles.

The basic structure of the organic transistor element is shown in figure 1. The gate electrode, the gate insulating film and source/drain electrodes are formed sequentially on the substrate and an organic semiconductor material is filled in between source/drain electrodes to form an organic semiconductor layer. Also, the insulating film between layers and the upper electrode covering the organic semiconductor layer and source/drain electrodes are formed, a transistor part and the upper electrode are electrically connected via a through hole provided in the insulating film between layers.

It is possible to restrict the forming of unnecessary channels in the organic semiconductor layer using a mixture of organic materials and inorganic materials as the insulating film between layers of the transistor element having such a structure. This is because an interface with the organic semiconductor layer becomes coarse by using the insulating film between layers with inorganic particles dispersed in the organic material. Since the interface with the organic semiconductor layer is coarse, an electric field effect by electrical current potential of the upper electrode is hard to have an effect and it is hard for the insulating film between layers to act as the gate insulating film. It is thought that the interface between the insulating film between layers and the organic semiconductor layer in the present invention is formed by particles included in the insulating film between layers where a degree of unevenness is about 20 nm to 1 $\mu$m.

Also, as for further effect of using the above materials as the insulating film between layers, it is easy to control the thickness of the film and a dielectric constant. When dispersed inorganic particles in organic materials dissolved in a medium are used, for example, films using a printing process like a screen process can be formed. Thus, it is possible to form the insulating film between layers which is thicker than that of conventional materials. Also, control of the dielectric constant is easy by selecting kinds of materials.

As examples of organic materials used in the present invention, there are materials including polyvinyl alcohol resin, polyvinyl acetal resin, acrylic resin, ethyl cellulose resin, etc. Also, as examples of inorganic particles, there are silica ($SiO_2$), alumina ($Al_2O_3$), titanium oxide ($TiO_2$), zinc oxide (ZnO), and barium titanate ($BaTiO_3$). Especially, materials which have low relative dielectric constant comparatively such as silica, alumina and zinc oxide are preferable. Also,

the material may be inorganic porous particles having meso holes or micro holes in its structure like mesoporous silica, for example.

Particle diameter of inorganic particles used in the present invention is 20 nm or above and not more than 2 μm. In figure 2, a distribution of particle diameter of inorganic particles used in the present invention is shown, where the distribution of particle diameter is measured with methods like the dynamic light scattering method or the laser beam diffraction method. In general, particle-shaped materials have a distribution of particle diameter, but "particle diameter" means average diameter ($d_{50}$) of particles, that is, "particle diameter" used here shows the diameter where volume frequency of accumulation becomes 50% among the provided distribution of particle diameters (average diameter, $d_{50}$). When the particle diameter is too small, it is difficult to disperse the particles in organic materials, so the particle diameter is at least 20 nm or above, more preferably, the particle diameter is 40 nm or above. Also, when the particle diameter is too large, the insulating film becomes unbalanced, so the particle diameter is selected to be not more than half size of the thickness of the film; more preferably, the particle diameter is not more than 1/5 of the thickness of the film. Preferably, the particle diameter is not more than 2 μm, and more preferably, the particle diameter is not more than 1 μm. As inorganic particles, one kind of material may be used or plural materials that have different compositions or particle diameter distributions can be mixed, as necessary.

Also, there is no limitation as a mixture ratio of organic materials and inorganic materials, but it is preferable that the proportion of organic materials be higher than the proportion of inorganic materials for the mixture ratio so that flexibility is provided to the insulating film between layers. It is preferable that the ratio in volume of organic materials to the insulating film between layers is 30% or more; over 50% is more preferable. Coarseness of an interface of the organic semiconductor layer and the insulating film between layers is determined by particle diameter and combination ratio of used inorganic particles. Thus, depending on an assumed formation method and the thickness of the film, appropriate materials and combination ratio can be selected.

The thickness of the insulating film between layers used for the present invention is 2 μm or above and not more than 40 μm. There is an effect that capacitance becomes small by thickening the insulating film between layers. Thus, it is preferable that the thickness be 2 μm, and 4 μm or above is more preferable. Also, as forming means of the insulating film between layers of the present invention, printing processes like screen printing and intaglio printing are suitable. The range of thickness of the insulating film between layers of the present invention is a range that can be formed suitable for printing methods. For example, when a fine pattern which is assumed in the present invention is formed using screen printing, a film can be formed by coping pasted materials which are supplied in mesh having 15-50 μm of line diameter and 40-60% of aperture rate. Thus, the thickness of the insulating film between layers can be stable within the above range and through holes can be formed.

The capacitance per unit area of the gate insulating film is 3 times or more as great as the capacitance per unit area of the insulating film between layers used in the present invention. Thus, certainly, forming of unnecessary channels in the organic semiconductor layer can be prevented.

In general, the capacitance of the insulating film between layers is defined as follows, thin layered samples are placed at upper and lower position for making electrodes, and the capacitance can be measured using a general LCR meter.

$$C = \varepsilon o \varepsilon rS/d$$

C: capacitance[F], ε o: dielectric constant in a vacuum[F/m], ε r: relative dielectric constant [-], S: area[$m^2$], d: thickness of the film[m]

Therefore, the capacitance per unit area is C = ε o ε r/d, and it is a function of the relative dielectric constant and the thickness of the film. Here,' capacitance ratio (Cr) per unit area of the gate insulating film compared to the capacitance per unit area of the insulating film between layers is defined as follows.

$$Cr = C_G/C_I$$

$C_I$: capacitance per unit area of the insulating film between layers, $C_G$: capacitance per unit area of the gate insulating film.

In the above non-patent document 1, capacitance of the insulating film between layers is almost 1/20 of the capacitance of the gate insulating film. That is, Cr value defined above is almost 20, but the OFF-current is increased by influence of pixel electrodes.

Here, Cr of the transistor where $C_I$ is changed by changing relative dielectric constant and thickness of the film of the insulating film between layers of the present invention, and its ON/OFF ratio (a ratio of current for on and current for off flowing through the source/drain electrodes) are shown in figure 3. The ON/OFF ratio is $4.5 \times 10^4$, when Cr is 3.1

(an element in example 1 described below). However, when Cr is smaller than this value, the ON/OFF ratio is drastically decreased. When Cr is 2.5, the ON/OFF ratio is $7.2 \times 10^3$ which is decreased by one order of magnitude, and good transistor performance is not provided. That is, the OFF-current is increased by forming unnecessary channels in the organic semiconductor layer. Therefore, for the transistor element using the insulating film between layers of the present invention, when the Cr value is at least 3 or above, it is hard to form unnecessary channels in the organic semiconductor layer. Thus, the increase of the OFF-current can be prevented. A more preferable Cr value is 10 or above.

As an example of the present invention, capacitance is measured at the time of applying voltage at 1 kHz with impedance analyzer 4194A (Hewlett Packard), and relative dielectric constant is calculated.

Also, as shown in figure 4, it is effective means for achieving the object of the present invention that the upper electrode be placed at a position not covering a channel forming part of the organic semiconductor layer as viewed in plan view. (Especially, see figure 4(B) of the plan view.) The channel forming part means a part between source and drain of the organic semiconductor layer, as shown in figure 5. By applying voltage to the gate electrodes, a channel is formed near the gate insulating film of the channel forming part and current flows between source and drain electrodes. On the other hand, when voltage is applied to the upper electrode, channels are formed near the insulating film between layers of the channel forming part and there are cases where unnecessary current will flow.

The present invention means that the upper electrode is placed on a position where an electric field effect does not affect the organic semiconductor channel forming part via the insulating film between layers when voltage is applied, and also, the organic semiconductor layer is placed in a position where it is between upper electrodes that are next to each other as viewed in plan view. Therefore, a part of the upper electrode may cover only a part of the organic semiconductor layer.

For a conventional transistor (for example, see the patent document 4), there is a structure where the channel part is placed to avoid being beneath the upper electrode, and there is a complicated structure providing a shading film on upper and lower sides of the active layer for preventing an occurrence of light leakage current by which light is incident on the active layer. However, for the present invention, the insulating film is made of a mixture of organic materials and inorganic materials, so that light is scattered at the interface of the organic materials and inorganic particles. In addition, it is hard for light to be incident on the organic semiconductor layer because the thickness is so thick. Therefore, for the transistor of a simple structure not having the shading film, the object of the invention can be achieved by placing the upper electrode at the position not covering the channel forming part of the organic semiconductor layer.

Also, outbreak of the light leakage current can be suppressed effectively because the light which is incident on the insulating film between layers is absorbed and the incidence of the light onto the organic semiconductor layer can be prevented by including color ingredients having light absorbing properties in materials of the insulating film between layers. For kinds of color ingredients to be used, there is no limitation for insulating materials whose particle diameter is between about 20 nm-2 $\mu$m, and conventionally well-known natural color ingredients or complex color ingredients can be used.

Next, the general structure of the transistor element of the present invention is explained.

The insulated substrate may be one of an insulated resin substrate, glass substrate, semiconductor substrate and ceramics substrate, but is not limited to one of these, and in the case of a display device to which the transistor element of the present invention is applied, it is preferable that the insulated substrate be a resin substrate. For the resin materials to be used there are, for example, thermoplastic resin like styrene system polymer, styrene-butadiene copolymer, styrene-acrylonitrile copolymer, styrene-maleic acid copolymer, acrylic copolymer, stylene-acrylic acid copolymer, polyethylene, ethylene-vinyl acetate copolymer, hydrochloric acid polyethylene, polyvinyl chloride, polypropylene, vinyl chloride-vinyl acetate copolymer, polyester alkyd resin, polyamide, polyimide, polyurethane, polycarbonate, polyallylate, polysulfone, diallyl phthalate resin, ketone resin, polyvinyl butyral resin, polyether resin, and polyester resin; bridging-thermosetting resin like silicone resin, epoxy resin, phenol resin, urea resin, melamine resin and so on; also, light-setting resin like epoxy acrylate, urethaneacrylate, and so on. From the view point of heat resistance and being damp-proof, polyimide is preferable and SE-1180 (Nissan-kagaku) and AL3046 (JSR) are examples of commercial products.

The gate electrode is made of conductive materials, for example but not limited to, platinum, gold, silver, nickel, chrome, copper, iron, tin, antimony, lead, tantalum, indium, palladium, tellurium, rhenium, iridium, aluminum, ruthenium, germanium, molybdenum, tungsten, and these metal alloys; tin oxide antimony, indium tin oxide (ITO), indium zinc oxide (IZO), fluorine dope zinc oxide, zinc, carbon, a graphite, glassy carbon, silver paste and carbon paper paste, lithium, lithium fluoride, beryllium, potassium, calcium, scandium, titanium, manganese, zirconium, gallium, niobium, sodium, a sodium-potassium alloy, magnesium, a magnesium / copper mixture, a magnesium / silver mixture, a magnesium / aluminum mixture, a magnesium / indium mixture, an aluminum / aluminum oxide mixture, a lithium / aluminum mixture or these in a layered stack can be used. Especially, among this, from the view point of stability in air, platinum, gold, silver, copper, aluminum, indium, ITO, IZO and carbon are preferable.

Also, a heated and fusion-bonded body of electrically-conductive particles can be used for the gate electrode. As electrically-conductive particles, metallic particles such that the average particle diameter (diameter) is 1-50 nm, and preferably, the average particle diameter is 1-10 nm for platinum, gold, silver, copper, cobalt, chrome, iridium, nickel,

palladium, molybdenum, tungsten as examples.

Also, carbon materials like conductive carbon black, carbon nanotube, and fullerene (C60, C70) can be used.

The film thickness is between 10 nm and 1000 nm, for example, and preferably, it is set between 100 nm and 1000 nm for the gate insulating film; insulating materials can be used and these materials may be organic materials and inorganic materials within the range of insulating materials. As organic materials, for example, there are poly chloropyrene, poly ethylene terephthalate, polyoxymethylene, polyvinyl chroride, polyvinylidene fluoride, cyano ethyl pullulan, polymethylmethacrylate, poly sulfone, polycarbonate, polyimide, polyethylene, polyester, polyvinyl phenol, melamine resin, phenolic resin, fluoric resin, polyphenylene sulfide, poly paraxylene, and polyacrylonitrile. Also, as inorganic materials, for example, there are silicon oxide, silicon nitride, aluminum oxide, aluminum nitride, titanium oxide, and silicon nitride oxide. Also, each kind of insulated Langmuir-Blodgett film, etc., can be used for the gate insulating film. The film is not limited to these materials; a mixture of two of these materials may be used, and an insulating film comprising different materials can be formed with two layers or more than two layers.

Among the insulating materials, from the view point of relative dielectric constant, silicon nitride, aluminum oxide, aluminum nitride, titan oxide and silicon nitride oxide are preferable. The relative dielectric constant of the whole gate insulating film is increased'and the gate leakage current can be more restricted. Also, the insulating materials can be selected depending on the improvement for adhesive strength of the gate electrode.

There is no limitation for the forming method of the gate insulating film; for example, there are the CVD method, plasma CVD method, plasma polymerization method, vacuum deposition method, sputtering method, spin coating method, dipping method, cluster ion beam evaporation method and Langmuir-Blodgett method; each method can be used.

The source/drain electrodes are separated from each other with a space so as to face the gate electrode on the opposite side of the gate insulating film. For example, a long direction of the gate is between 1 $\mu$m and 1000 $\mu$m, a width direction of the gate is between 5 $\mu$m and 4000 $\mu$m, and a spacing gap of the long direction of the gate of two source/drain electrodes is set within a range of 0.01 $\mu$m and 1000 $\mu$m. However, the source/drain electrodes can be set depending on structures of the transistor.

Also, the thickness of the film of the source/drain electrodes is preferably set within a range of between 10 nm and 200 nm, but the thickness of the film can be set depending on the structure.

Materials for the source/drain electrodes can be materials the same as the gate electrode described above. Also, conductive materials which are dissolved or diffused in organic solvent or water can be used. Since such kinds of conductive materials can be applied as a coating, manufacturing cost can be reduced compared to vacuum processes such as vacuum deposition methods.

As for the conductive materials which are dissolved or diffused in an organic solvent or water used for source/drain electrodes, for example, these are silver paste, gold paste, copper paste, and a polymer mixture with scattered electrically-conductive particles in an organic solvent like graphite ink and an electro-conductive organic material.

The electro-conductive organic material used for the source/drain electrodes is more preferable than metallic materials due to the following points. That is, when materials of the electrode are metal, an interface tension between metal and organic matter of the organic semiconductor layer is big. Thus, it is reported that an arrangement of organic molecules of an interface neighborhood is disturbed, and a trap site of a carrier is formed, so that an element characteristic turns worse (J. Wang, D.J. Gundlach, C.C. Kuo, and T.N. Jackson, 41st Electronic Materials Conference Digest, p.16, June 1999). Thereby, the interface tension is reduced by applying electro-conductive organic materials to electrode materials, and aggravation of an element characteristic can be prevented.

As such electro-conductive organic materials, for example, there are conjugated system macromolecules such as polyacetylene, polypyrrol, polythiophen, polyparaphenylene, polyparaphenylene vinylene, polythienylene vinylene, polyfuloleine, polyacene, polyfran and their derivatives. Also, any suitable dopant with high conductivity may be used by doping. As for dopants, from a view point of diffusion stability in solution, it is preferable that poly sulfonic acid, polystyrene sulfonate, naphthalene sulfonic acid, or alkyl naphthalene sulfonic acid, in which vapor pressure is low, be used. Also, these conductive materials which are dissolved or diffused in organic solvent or water may be used for the gate electrode.

Also, examples of commercial products of these conductive materials which are dissolved or diffused in organic solvent or water are Perfect Gold (trademark)(gold paste, SinkuYakin), Perfect Copper (copper paste, SinkuJigane), Orgacon Paste variant 1/4 (Printing transparent PEDOT/PSS ink, Nippon Agfa Gewalt), Paste variant 1/3 (Printing transparent PEDOT/PSS ink, Nippon Agfa Gewalt), Orgacon Carbon Paste variant 2/2 (carbon electrode paste, Nippon Agfa Gewalt), BAYTRON (trademark) P (PEDT/PSS solution, Nippon Stalk Vitech).

Also, it is preferable that electrode materials, forming ohmic contact with the organic semiconductor layer be used for materials of source/drain electrodes. An energy barrier between source/drain electrodes and the organic semiconductor layer can be reduced. Concretely, when a p-type semiconductor, in which the carrier is a hole, is used for the organic semiconductor layer, electrode materials that have a work function (energy difference from a vacuum level to a fermi level) of electrode materials that is bigger than a work function of the organic semiconductor layer are preferable

and, for example, these are gold (5.1 eV), platinum (5.65 eV), iridium (5.27 eV), palladium (5.12 eV), nickel (5.15 eV), tin indium oxide (ITO) and zinc oxide (ZnO). Also, when an n-type semiconductor is used for the organic semiconductor layer, electrode materials that have a work function that is smaller than a work function of the organic semiconductor layer are preferable and, for example, these are alkaline-earth metals like magnesium (3.66 eV), barium (2.7 eV), gallium (4.2 eV), indium (4.12 eV), aluminum (4.28 eV) and silver (4.26 eV). Here, numerical values in parenthesis show a work function. Concretely, combinations of source/drain electrode materials and organic semiconductor layer materials may be selected so as to decrease electric resistance at the contact surface of these materials by consulting current-voltage characteristics of the display device using the transistor element of the present invention. ,

Also, two source/drain electrodes may comprise materials having different work functions from each other. When a p-type semiconductor, in which the carrier is a hole, is used for the organic semiconductor layer, it is selected so that the work function of the drain electrode materials is smaller than that of the source electrode materials within two source/drain electrodes. Thereby, a potential difference occurs in the same direction when negative voltage of source to drain is applied, and the voltage applied as voltage of source and drain can be reduced. For example, gold is used for the source electrode and silver is used for the drain electrode. Also, when an n-type semiconductor is used for the organic semiconductor layer, materials of the drain electrode can be replaced with materials of the source electrode.

As for the manufacturing method for forming the gate electrode and source/drain electrodes, there is a method where these electrode patterns are manufactured with a well-known photolithography method, liftoff method, and conductive film, in which the above conductive materials are deposited with the evaporation method or a sputtering method; also there is a method where a resist pattern is formed by heat transcription or ink-jetting on metallic foils such as aluminum or copper, so that an electrode is formed by etching. In addition, in conductive polymeric liquid or dispersion, a conductive particle dispersion is jetted with direct ink jet devices, and an electrode may be formed. Also, an electrode may be formed by patterning the coating film applied using conductive ink or conductive paste including carbon black, conductive polymer and conductive particles using the lithography method or laser ablation method. Also, an electrode may be formed by patterning with conductive ink or conductive paste using printing methods like relief printing, intaglio printing, planography printing and screen printing.

A cross section of source/drain electrodes is shown in figures 1 and 4; also, they may be taper-shaped and any other shape.

As for materials of the organic semiconductor layer, well-known organic semiconductor materials can be used. Especially, it is preferable for manufacturing handling and manufacturing cost that organic semiconductor materials like organic low molecule, organic high molecule and organic oligomer which can be applied as a coating be used. As materials for organic low molecules and organic oligomers, for example, there are anthracene, tetracene, pentacene, acene, molecule materials including those substitution derivatives, metallic phthalocyanine, thiophen oligomer and its derivatives, fullerene C60, and carbon nanotube and its derivatives. Generally, low molecular materials like pentacene are layered with a vapor evaporation method, but a method in which pentacene film is formed by chemically changing after being applied as a coating with pentacene precursor described in J.E. Anthonyra et al., Org. Lett. Vol.4 p.15 (2002) and P.T. Herwig et al., Adv. Mater. Vol.11, p.480 (1999), may be used.

Also, as for organic high molecular materials, $\pi$ type electronic conjugated high molecule and $\sigma$ type electronic conjugated high molecule and their derivatives are used. As for $\pi$ type electronic conjugated high molecule, for example, there are polypara phenylene, polyacetylene, polypyrrol, poly thiophen, polyfran, polyselenophene, polyaniline, polyazulene, polypyrene, polyfluorene, polypara phenylene vinylene, polythieylenevinylene, polybenzofran, polybenzothiophen, polyindole, polycarbazole, polydibenzofuran, polyisothianaphtene, polyisonapthothiophen, polydiacetylene, polyphenylenesulfide and polyphenyleneoxide. Also, deoxyribo nucleic acid (DNA) can be used as biomaterials. A charge transfer complex comprising electronic acceptors and electronic donors can be used. Also, as examples for electronic acceptors, there are 2,3-dichorolo-5,6-dicyano-p-bennzoquinone, 2,5-dimethlytetracyanoquinodimethane, and tetracyanoquinodimethane. As examples for electronic donors, there are dibenzotetrathiafulvalene, tetraselenafulvalene, tetrathiafulvalene, tetrathiatetracene, and tetramethyltetrathiafulvalene. The above organic semiconductor materials are used as mixture of these multiple materials or used as dispersed in binder resin.

As for organic semiconductor layer materials, a mixture of high molecular organic semiconductor materials having high carrier density and low molecular organic semiconductor materials having low carrier density can be used. The drain OFF-current is reduced, and reduction of a carrier mobility can be avoided. Examples of high molecular organic semiconductor materials having high carrier density are polyfluorene derivatives, and examples of low molecular organic semiconductor materials having low carrier density are butadiene derivatives or aromatic tertiary amine derivatives used as electric charge outbreak materials.

As for the forming method of the organic semiconductor layer, there are coating methods such as a spray coat method, a spin coat method, a blade coat method, a dip lotion coat method, the cast method, a roll coat method, a bar coat method, a die coat method, screen method and LB method, vacuum deposition method, molecule epitaxial growth method, an ion cluster beam method, low energy ion beam method, ion plating method, CVD method, sputtering method, plasma polymerization method, electrolysis polymerization method, and chemical polymerization. They can use depending on materials of the organic semiconductor layer.

The shape of the surface of the organic semiconductor layer is not limited to a convex surface shown in figure 4 and 5, but it may be formed in a shape that is superior in adhesion with the insulating film between layers, and is superior in coatability of the insulating film between layers.

As shown figure 4 and 5, two source/drain electrodes contact the organic semiconductor layer only at a part, but most parts of them are exposed. Therefore, the transistor element of the present invention has a structure where the insulating film between layers is formed contacting the exposed surfaces of the organic semiconductor layer and the source/drain electrodes. Thereby, flowing of the current from the electrode surface via the organic semiconductor layer is prevented, the drain OFF-current is restricted, and they contribute to the improvement of the ON/OFF ratio.

The insulating film between layers which has an effect of the transistor element of the present invention has characteristics where forming of unnecessary channels in the organic semiconductor layer is restricted, and the insulating film between layers is formed as described above.

One example of a display device using the transistor element of the present invention shown in figure 4 is shown in figure 6. The transistor element of the present invention is used as switching element (also, it is called as control element) to control displaying state of the image display element. For example, the transistor elements of the present invention are formed in multiple on the substrate with lattice shape (active matrix substrate); also a display device with transistor elements as switching element corresponding to the image display element are formed multiple can be formed. Thereby, as for the image display element layered on the active matrix substrate providing transistor elements of the present invention, methods such as liquid crystal, electrophoretic, organic electroluminescence can be used.

Shown in figure 6 is a typical structure of the display device in which the image display element and second substrate are layered in order on the transistor element of the present invention shown figure 4(A). Glasses and plastics like polyester, polycarbonate, polyallylate, polyeter and sulfone can be used for the second substrate.

Since the liquid crystal display element using liquid crystal as the image display element is powered by electric field, its power consumption is small, and since the drive voltage is low, the drive frequency of the TFT can be increased; thereby the liquid crystal display element can be suitable for large size displays. Concerning displaying methods of liquid crystal elements, for example, there are TN, STN, guest/host-type and polymer-dispersed liquid crystal (PDLC); especially, PDLC is preferable for the reason that a bright white indication is provided with a reflection type. The display device which has good performance and is a thin and light-weight flat panel type can be provided by combining the liquid crystal display element and the transistor of the present invention.

Also, the electrophoretic display element in which the insulating liquid and electrically charged particle in the insulating liquid are dispersed can be used as the image display element. The electrophoretic display element comprises dispersion in which particles having the first color (for example, white) are dispersed in a coloring dispersion having the second color. In the coloring dispersion, the position of particles having the first color can be changed due to the effect of an electric field and the particles are charging in the coloring dispersion, and thereby a color to present changes. According to this display method, a display that is bright and has a wide view angle can be provided. In addition, it is preferable that the electrophoretic element be used from the viewpoint of power consumption in particular so that displaying memory characteristics are provided.

By making the dispersions a wrapped microcapsule with a macromolecule membrane, display performance is stabilized, and also production of the display device becomes easy. The microcapsule can be formed with well-known methods such as core cellvation method, In-Situ polymerization method and interface polymerization method. Especially, titan oxide is preferable used for white particles, and surface treatment or combination with other materials is processed as necessary. Concerning the dispersions, organic solvent which has high resistivity like benzene, toluene, xylene, aromatic hydrocarbons such as naphthenic hydrocarbons, hexane, cyclohexane, kerosene, aliphatic hydrocarbons such as paraffin system hydrocarbons, trichloroethylene, tetrachloroethylene, trichlorofluoroethylene, halogenated hydrocarbons such as ethyl bromides, fluorine ether compound, fluorine ester compound and silicone oil can be used preferably. In order to color the dispersion, oil-soluble dye such as anthraquinones or azo-compounds having a desired absorption characteristic is used. Surfactants may be added to the dispersions in order to stabilize the dispersion.

There are few burdens applied to human eyes, so a display device which has good performance can be provided by combining the transistor element of the present invention with the electrophoretic display element. The electrophoretic display element is an image display element which has low driving electricity and high contrast. Thus, the display device which has good performance and is a thin and lightweight flat panel type can be provided by combining the electrophoretic display element with the transistor of the present invention.

Because the organic electro luminescence element is a spontaneous light type, bright full color display can be performed. Also, because the organic electro luminescence element has a very thin organic layer, it has high flexibility and it is suitable to be formed on the flexible substrate. Thus, a thin and light-weight display device which has good performance and is flexible can be provided by combining the electro luminescence element with the transistor of the present invention.

Also, concerning the transistor element and the display device using the transistor element of the present invention, these manufacturing methods are same as well-known manufacturing methods, thus explanation of these methods is omitted. However, the insulating film between layers comprising the mixture of organic materials and inorganic materials that is characterized in the transistor element of the present invention is different in its manufacturing method from the conventional method. It is preferable to form the insulating film between layers with the screen printing method. For the conventional method forming through holes after forming the insulating film between layers, there is a problem in that the transistor is damaged by the etching process for opening the through holes. However, when the screen printing method is used, the transistor is not damaged because films can be formed in advance on areas except the through hole regions. Also, while efficient use of materials and a simple process are realized, the object of the invention can be achieved.

EXAMPLES

In the below, the present invention is explained by means of the following examples more concretely, but the present invention is not limited to the following examples.

Example 1

The gate electrode is formed on the polycarbonate substrate by that nano-silver ink is formed in predetermined pattern with inkjet method and by the drying process. Then, the gate insulating film is formed such that heat polymerization type polyimide is coated by means of the spin coat, and it was heat-treated at 190 °C. The formed gate insulating film had relative dielectric constant of 3.6 and the film thickness of 0.4 μm. Ultraviolet irradiation is performed on the source/drain electrode forming part via a photomask, thereby a surface reforming was performed. Further, source/drain electrodes were obtained by nano-silver ink being formed as a pattern with the inkjet method.

The organic semiconductor material shown in below formula 1 was dissolved in xylene; after making ink, the active layer was made with the film formation by the ink-jet method in a part desired. Thereby, the organic transistor was obtained. The channel length of the transistor was 5 μm, and channel width was 2000 μm.

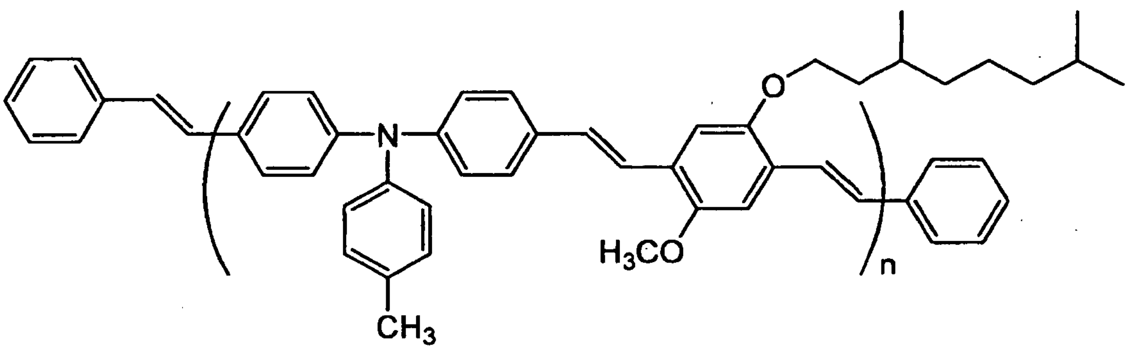

For the insulating film between layers, titan oxide valium (A in figure 2), in which the average particle diameter is 0.16 μm and relative surface area is 13 $m^2/g$, was added to solution where polyvinylacetal resin is dissolved in solvent so that its weight ratio becomes 1:2, and paste was prepared by mixing them with a roller mill. This insulating paste was transcribed on the transistor except through hole regions with the screen printing method, then the insulating film between layers was formed by drying the solvent. For forming the insulating film between layers, the ratio in volume of polyvinylacetal was 30%, thickness was 11 μm and relative dielectric constant was 32.

The ratio of capacitance per unit area of the gate insulating film to the capacitance per unit area of the insulating film between layers is 3.1 as shown in the following formula.

$$CG/CI=(\varepsilon rG/dG)/(\varepsilon rI/dI)=(3.6/0.4)/(32/11)=3.1$$

Finally, silver paste comprising Ag particles, acryl resin and solvent as the upper electrode materials was formed using the screen printing method, and a pixel electrode was formed by drying the solvent. Printing was performed on a pad area of the gate electrode and a pad area of the drain electrode in a shape such that the pixel electrode material existed on an opening region of the insulating film between layers.

The transistor performance was evaluated with the semiconductor parameter analyzer.

A measurement condition: Set VDS=-20 V, results of the upper electrode for 0 V (connected to the source electrode) and -20 V (connected to the drain electrode) are shown in table 1 and figure 7. Vertical axis (Id) of figure 7 indicates current value which flows between the source and the drain, and horizontal axis Vg of figure 7 indicates the gate voltage. Also, the ON-current and the OFF-current indicate current values for Vg=-20V and +20V in table 1, respectively. Referring to figure 7, it is not recognized that the OFF-current had a big change whether the upper electrode is either 0 V or -20 V. However, it is confirmed that the influence which transistor performance receives from electrical potential of the upper electrode is small.

TABLE 1

| | UPPER ELECTRODE 0V | UPPER ELECTRODE -20V |
|---|---|---|
| ON CURRENT [A] VG=-20V | $8.6 \times 10^{-7}$ | $9.8 \times 10^{-7}$ |
| OFF CURRENT [A] VG=20V | $1.8 \times 10^{-11}$ | $2.2 \times 10^{-11}$ |
| THRESHOLD VOLTAGE [V] | -1.8 | 0.3 |

As the result, it is confirmed that the transistor performance is independent of electrical potential of the upper electrode.

(Comparative example 1)

The organic transistor as same as the example 1 was prepared.

The insulating film between layers was formed such that after 1 μm thickness of para xylene dimmer is formed by evaporation, and through holes were opened by Ar etching. After that, the upper electrode was formed the same as above.

The same as example 1, evaluation results of the transistor performance for 0 V (connected to the source electrode) and -10 V (connected to the drain electrode) are shown in table 2 and figure 8. The same as figure 7, vertical axis (Id) of figure 8 indicates current value which flows between the source and the drain, and horizontal axis Vg of figure 8 indicates the gate voltage. Also, the ON-current and the OFF-current indicate current values for Vg=-15 V and +15 V in table 2, respectively. As the result of comparative example 1, the result is that the OFF-current was increased by forming the channel in the off region in the organic semiconductor when the upper electrode was connected to the drain electrode.

TABLE 2

| | UPPER ELECTRODE: 0V | UPPER ELECTRODE : -10V |
|---|---|---|
| ON CURRENT [A] VG=-15V | $3.5 \times 10^{-7}$ | $5.6 \times 10^{-7}$ |
| OFF CURRENT [A] VG=15V | $3.2 \times 10^{-11}$ | $4.8 \times 10^{-10}$ |
| THRESHOLD VOLTAGE [V] | -0.4 | 6.5 |

(Example 2)

The organic transistor the same as the example 1 was prepared.

For the insulating film between layers, silica (B in figure 2), in which the average particle diameter is 40 μm and relative surface area is 80 $m^2/g$, was added to a solution so that polyvinylacetal resin is dissolved in solvent so that its weight ratio becomes 2:1, and paste was prepared by mixing them with a roller mill. This insulating paste was transcribed on the transistor except through hole regions with the screen printing method, then the insulating film between layers was formed by drying the solvent. For the formed insulating film between layers, the ratio in volume of polyvinylacetal was 51%, thickness was 4 μm and relative electric constant was 3.6.

The ratio of capacitance per unit area of the gate insulating film to the capacitance per unit area of the insulating film between layers of this example is 10 as shown in the following formula.

$$CG/CI=(\varepsilon rG/dG)/(\varepsilon rI/dI)=(3.6/0.4)/(3.6/4)=10$$

Silver paste comprising Ag particles, acryl resin and solvent as the upper electrode materials was formed using the screen printing method such that the channel forming part of the organic semiconductor is placed under gaps between upper electrodes, and a pixel electrode was formed by drying the solvent.

The same as example 1, evaluation results of the transistor performance with the semiconductor parameter analyzer are shown in table 3 and figure 9. The same as figure 7 and 8, the vertical axis (Id) of figure 9 indicates current value which flows between the source and the drain, and the horizontal axis Vg of figure 9 indicates the gate voltage. Also, the ON-current and the OFF-current indicate current values for Vg=-20 V and +20 V in table 3, respectively. As the result of example 2, it was confirmed that the influence on the transistor characteristic due to the electrical potential of the upper electrode is small, and there is almost no increase of the OFF-current.

TABLE 3

| | UPPER ELECTRODE : 0V | UPPER ELECTRODE : -20V |
|---|---|---|
| ON CURRENT [A] VG=-20V | $2.1 \times 10^{-6}$ | $2.0 \times 10^{-6}$ |
| OFF CURRENT [A] VG=20V | $5.1 \times 10^{-11}$ | $4.8 \times 10^{-11}$ |
| THRESHOLD VOLTAGE[V] | 1.7 | 2.5 |

As described above, for elements that the transistors using an organic semiconductor layer on the substrate, the insulating film between layers contacting the organic semiconductor layer and the upper electrode electrically contacting the transistors via through holes provided in the insulating film between layers, by using the insulating film between layers comprising organic materials and particles, unnecessary channels are hard to be formed in the organic semiconductor layer and it is possible to obtain transistor elements which have a superior ON/OFF ratio.

**Claims**

1. An organic transistor element comprising
a transistor comprising a gate electrode, a gate insulating film and source/drain electrodes formed sequentially on a substrate, and
an organic semiconductor filled in between source and drain electrode; an insulating film between layers contacting the organic semiconductor; and
an upper electrode on the insulating film between layers, the upper electrode electrically contacting the transistor via a through hole provided in the insulating film between layers,
wherein the insulating film between layers comprises inorganic particles dispersed in organic material.

2. The transistor element as claimed in claim 1, wherein a particle diameter of the particles which comprise the insulating film between layers is not more than 1/2 of a thickness of the insulating film between layers.

3. The transistor element as claimed in claim 1 or 2, wherein a ratio in volume of the organic materials to the insulating film between layers is 30% or more.

4. The transistor element as claimed in any one of claims 1 to 3, wherein the thickness of the insulating film between layers is 2 $\mu$m or above and not more than 40 $\mu$m.

5. The transistor element as claimed in any one of claims 1 to 4, wherein a capacitance per unit area of a gate insulating film of the transistor is 3 times or more as great as a capacitance per unit area of the insulating film between layers.

6. The transistor element as claimed in any one of claims 1 to 5, wherein the upper electrode is placed in a position not covering a channel forming part of the organic semiconductor layer as viewed in plan view.

7. The transistor element as claimed in any one of claims 1 to 6, wherein the mixture of organic materials and particles comprising the insulating film between layers includes a color ingredient having light absorbing property.

8. A display device in which the transistor element as claimed in any one of claims 1 to 7 is used as a switching element corresponding to an image display element.

9. A display device, comprising
a plurality of the transistor elements as claimed in claims 1 to 7 provided on an active matrix substrate in a lattice pattern; and
an image display element provided on the transistor elements.

10. The display device as claimed in claim 8 or 9, wherein the image display element is selected from a group comprising a liquid crystal element, an electrophoretic display element and an organic electro luminescence element.

11. A manufacturing method of an organic transistor element, comprising
forming a transistor comprising a gate electrode, a gate insulating film and source/drain electrodes sequentially on a substrate, and
filling in an organic semiconductor between source and drain electrode;
providing an insulating film between layers contacting the organic semiconductor; and
providing an upper electrode on the insulating film between layers, the upper electrode electrically contacting the transistor via a through hole provided in the insulating film between layers,
wherein the insulating film between layers comprises inorganic particles dispersed in organic material is formed by a screen print method.

12. The manufacturing method of the transistor element as claimed in claim 11, wherein a particle diameter of the particles which comprise the insulating film between layers is not more than 1/2 of the thickness of the insulating film between layers.

13. The manufacturing method of the transistor element as claimed in claim 11 or 12, wherein a ratio in volume of the organic materials to the insulating film between layers is 30% or more.

14. The manufacturing method of the transistor element as claimed in any one of claims 11 to 13, wherein the thickness of the insulating film between layers is 2 $\mu$m or above and not more than 40 $\mu$m.

15. The manufacturing method of the transistor element as claimed in any one of claims 11 to 14, wherein a capacitance per unit area of a gate insulating film of the transistor is 3 times or more as great as a capacitance per unit area of the insulating film between layers.

16. The manufacturing method of the transistor element as claimed in any one of claims 11 to 15, wherein the upper electrode is placed in a position not covering a channel forming part of the organic semiconductor layer as viewed in plan view.

17. The manufacturing method of the transistor element as claimed in any one of claims 11 to 16, wherein the mixture of organic materials and particles comprising the insulating film between layers includes a color ingredient having light absorbing property.

**Patentansprüche**

1. Organisches Transistorelement, umfassend
einen Transistor umfassend eine Gate-Elektrode, einen Gate-Isolierfilm und Source-/Drain-Elektroden, die der Reihe nach auf einem Substrat gebildet sind, und
einen organischen Halbleiter, der zwischen Source- und Drain-Elektrode gefüllt ist,
eine Isolierfilm-Zwischenschicht in Kontakt mit dem organischen Halbleiter und
eine obere Elektrode auf der Isolierfilm-Zwischenschicht, wobei die obere Elektrode den Transistor über ein Durchgangsloch, das in der Isolierfilm-Zwischenschicht vorgesehen ist, elektrisch kontaktiert,
wobei die Isolierfilm-Zwischenschicht in organischem Material dispergierte anorganische Teilchen umfasst.

2. Transistorelement wie in Anspruch 1 beansprucht, wobei der Teilchendurchmesser der Teilchen, die von der Isolierfilm-Zwischenschicht umfasst sind, nicht mehr als 1/2 der Dicke der Isolierfilm-Zwischenschicht beträgt.

3. Transistorelement wie in Anspruch 1 oder 2 beansprucht, wobei das Volumenverhältnis von den organischen Materialien zur Isolierfilm-Zwischenschicht 30% oder mehr beträgt.

4. Transistorelement wie in irgendeinem der Ansprüche 1 bis 3 beansprucht, wobei die Dicke der Isolierfilm-Zwischenschicht 2 μm oder mehr und nicht mehr als 40 μm beträgt.

5. Transistorelement wie in irgendeinem der Ansprüche 1 bis 4 beansprucht, wobei die Kapazität pro Flächeneinheit eines Gate-Isolierfilms des Transistors mindestens 3-mal so groß wie die Kapazität pro Flächeneinheit der Isolierfilm-Zwischenschicht ist.

6. Transistorelement wie in irgendeinem der Ansprüche 1 bis 5 beansprucht, wobei die obere Elektrode in einer Position angeordnet ist, die in der Draufsicht einen kanalbildenden Teil der organischen Halbleiterschicht nicht bedeckt.

7. Transistorelement wie in irgendeinem der Ansprüche 1 bis 6 beansprucht, wobei die von der Isolierfilm-Zwischenschicht umfassten Mischung von organischen Materialien und Teilchen einen Farbbestandteil mit Lichtabsorptionsvermögen beinhaltet.

8. Displayvorrichtung, in der das Transistorelement wie irgendeinem der Ansprüche 1 bis 7 beansprucht als ein Schaltelement entsprechend einem Bilddisplayelement verwendet wird.

9. Displayvorrichtung, umfassend
eine Mehrzahl von den Transistorelementen wie in den Ansprüchen 1 bis 7 beansprucht, die auf einem aktiven Matrixsubstrat in einem Gittermuster bereitgestellt sind; und
ein Bilddisplayelement, das auf den Transistorelementen bereitgestellt ist.

10. Displayvorrichtung wie in Anspruch 8 oder 9 beansprucht, wobei das Bilddisplayelement ausgewählt ist aus einer Gruppe umfassend ein Flüssigkristallelement, ein elektrophoretisches Displayelement und ein organisches Elektrolumineszenzelement.

11. Verfahren zur Herstellung eines organischen Transistorelements, umfassend
das Bilden eines Transistors umfassend eine Gate-Elektrode, einen Gate-Isolierfilm und Source-/Drain-Elektroden der Reihe nach auf einem Substrat und
das Verfüllen eines organischen Halbleiters zwischen Source- und Drain-Elektrode,
das Bereitstellen einer Isolierfilm-Zwischenschicht in Kontakt mit dem organischen Halbleiter und
das Bereitstellen einer oberen Elektrode auf der Isolierfilm-Zwischenschicht, wobei die obere Elektrode den Transistor über ein Durchgangsloch, das in der Isolierfilm-Zwischenschicht vorgesehen ist, elektrisch kontaktiert,
wobei die Isolierfilm-Zwischenschicht in organischem Material dispergierte anorganische Teilchen umfasst und durch ein Siebdruckverfahren gebildet wird.

12. Verfahren zur Herstellung des Transistorelements wie in Anspruch 11 beansprucht, wobei der Teilchendurchmesser der Teilchen, die von der Isolierfilm-Zwischenschicht umfasst sind, nicht mehr als 1/2 der Dicke der IsolierfilmZwischenschicht beträgt.

13. Verfahren zur Herstellung des Transistorelements wie in Anspruch 11 oder 12 beansprucht, wobei das Volumenverhältnis von den organischen Materialien zur Isolierfilm-Zwischenschicht 30% oder mehr beträgt.

14. Verfahren zur Herstellung des Transistorelements wie in irgendeinem der Ansprüche 11 bis 13 beansprucht, wobei die Dicke der Isolierfilm-Zwischenschicht 2 μm oder mehr und nicht mehr als 40 μm beträgt.

15. Verfahren zur Herstellung des Transistorelements wie in irgendeinem der Ansprüche 11 bis 14 beansprucht, wobei die Kapazität pro Flächeneinheit eines Gate-Isolierfilms des Transistors mindestens 3-mal so groß wie die Kapazität pro Flächeneinheit der Isolierfilm-Zwischenschicht ist.

16. Verfahren zur Herstellung des Transistorelements wie in irgendeinem der Ansprüche 11 bis 15 beansprucht, wobei die obere Elektrode in einer Position angeordnet ist, die in der Draufsicht einen kanalbildenden Teil der organischen Halbleiterschicht nicht bedeckt.

17. Verfahren zur Herstellung des Transistorelements wie in irgendeinem der Ansprüche 11 bis 16 beansprucht, wobei die von der Isolierfilm-Zwischenschicht umfassten Mischung von organischen Materialien und Teilchen einen Farbbestandteil mit Lichtabsorptionsvermögen beinhaltet.

**Revendications**

1. Elément de transistor organique comprenant :

   un transistor comprenant une électrode grille, un film isolant de grille et des électrodes de source/déversoir formées de manière séquentielle sur un substrat, et
   un semi-conducteur organique déversé entre l'électrode source et l'électrode déversoir ; un film isolant entre les couches en contact avec le semi-conducteur organique ; et
   une électrode supérieure sur le film isolant entre les couches, l'électrode supérieure étant en contact électrique avec le transistor via un trou débouchant prévu dans le film isolant entre les couches,
   dans lequel le film isolant entre les couches comprend des particules non organiques dispersées dans le matériau organique.

2. Elément de transistor selon la revendication 1, dans lequel un diamètre particulaire des particules qui comprennent le film isolant entre les couches n'est pas supérieur à 1/2 d'une épaisseur du film isolant entre les couches.

3. Elément de transistor selon la revendication 1 ou 2, dans lequel un rapport en volume des matériaux organiques sur le film isolant entre les couches est de 30% ou plus.

4. Elément de transistor selon l'une quelconque des revendications 1 à 3, dans lequel l'épaisseur du film isolant entre les couches est de 2 $\mu$m ou plus et non supérieure à 40 $\mu$m.

5. Elément de transistor selon l'une quelconque des revendications 1 à 4, dans lequel une capacitance par unité de surface d'un film isolant de grille du transistor est 3 fois ou plus supérieure à une capacitance par unité de surface du film isolant entre les couches.

6. Elément de transistor selon l'une quelconque des revendications 1 à 5, dans lequel l'électrode supérieure est placée dans une position ne recouvrant pas un canal faisant partie de la couche de semi-conducteur organique, comme observé sur la vue en plan.

7. Elément de transistor selon l'une quelconque des revendications 1 à 6, dans lequel le mélange de matériaux organiques et de particules comprenant le film isolant entre les couches comprend un ingrédient de couleur ayant la propriété d'absorption de lumière.

8. Dispositif d'affichage dans lequel l'élément de transistor selon l'une quelconque des revendications 1 à 7, est utilisé en tant qu'élément de commutation correspondant à un élément d'affichage d'image.

9. Dispositif d'affichage comprenant :

   une pluralité d'éléments de transistor selon les revendications 1 à 7, prévus sur un substrat de matrice active selon un modèle en treillis ; et
   un élément d'affichage d'image prévu sur les éléments de transistor.

10. Dispositif d'affichage selon la revendication 8 ou 9, dans lequel l'élément d'affichage d'image est choisi dans un groupe comprenant un élément de cristal liquide, un élément d'affichage électrophorétique et un élément électroluminescent organique.

11. Procédé de fabrication d'un élément de transistor organique, comprenant les étapes consistant à :

    former un transistor comprenant une électrode grille, un film isolant de grille et des électrodes source/déversoir en séquence sur un substrat, et
    déverser un semi-conducteur organique entre l'électrode source et l'électrode déversoir ;
    prévoir un film isolant entre les couches en contact avec le semi-conducteur organique ; et
    prévoir une électrode supérieure sur le film isolant entre les couches, l'électrode supérieure étant électriquement en contact avec le transistor via un trou débouchant prévu dans le film isolant entre les couches,
    dans lequel le film isolant entre les couches comprend des particules non organiques dispersées dans le matériau organique est formé par un procédé de sérigraphie.

**12.** Procédé de fabrication de l'élément de transistor selon la revendication 11, dans lequel un diamètre particulaire des particules qui comprennent le film isolant entre les couches n'est pas supérieur à 1/2 de l'épaisseur du film isolant entre les couches.

**13.** Procédé de fabrication de l'élément de transistor selon la revendication 11 ou 12, dans lequel un rapport en volume des matériaux organiques sur le film isolant entre les couches est de 30% ou plus.

**14.** Procédé de fabrication de l'élément de transistor selon l'une quelconque des revendications 11 à 13, dans lequel l'épaisseur du film isolant entre les couches est de 2 $\mu$m ou plus et non supérieure à 40 $\mu$m.

**15.** Procédé de fabrication de l'élément de transistor selon l'une quelconque des revendications 11 à 14, dans lequel un capacitance par unité de surface d'un film isolant de grille du transistor est 3 fois ou plus supérieure à une capacitance par unité de surface du film isolant entre les couches.

**16.** Procédé de fabrication de l'élément de transistor selon l'une quelconque des revendications 11 à 15, dans lequel l'électrode supérieure est placée dans une position ne recouvrant pas un canal faisant partie de la couche de semi-conducteur organique, comme observé sur la vue en plan.

**17.** Procédé de fabrication de l'élément de transistor selon l'une quelconque des revendications 11 à 16, dans lequel le mélange de matériaux organiques et de particules comprenant le film isolant entre les couches comprend un ingrédient de couleur ayant la propriété d'absorption de lumière.

FIG.1

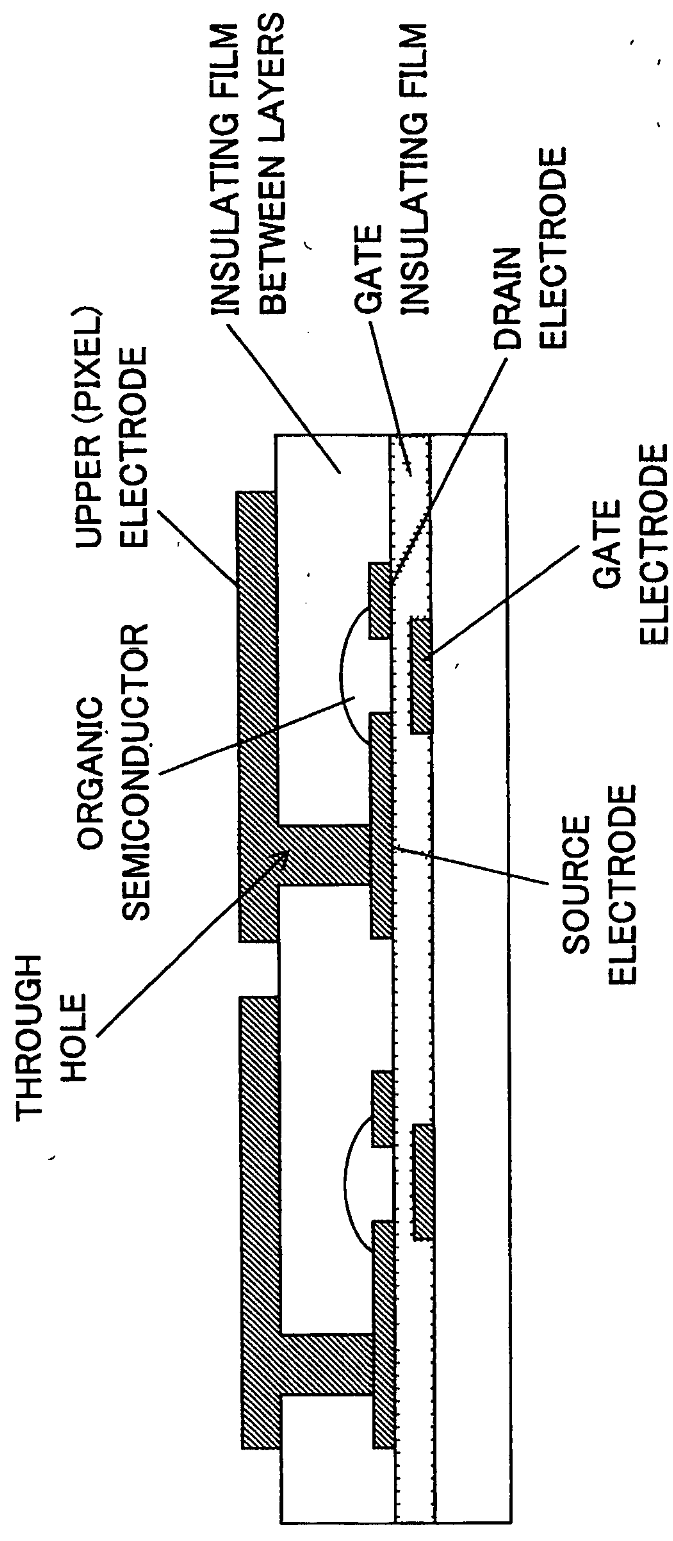
INSULATING FILM BETWEEN LAYERS
GATE INSULATING FILM
DRAIN ELECTRODE
UPPER (PIXEL) ELECTRODE
GATE ELECTRODE
ORGANIC SEMICONDUCTOR
SOURCE ELECTRODE
THROUGH HOLE

FIG.2

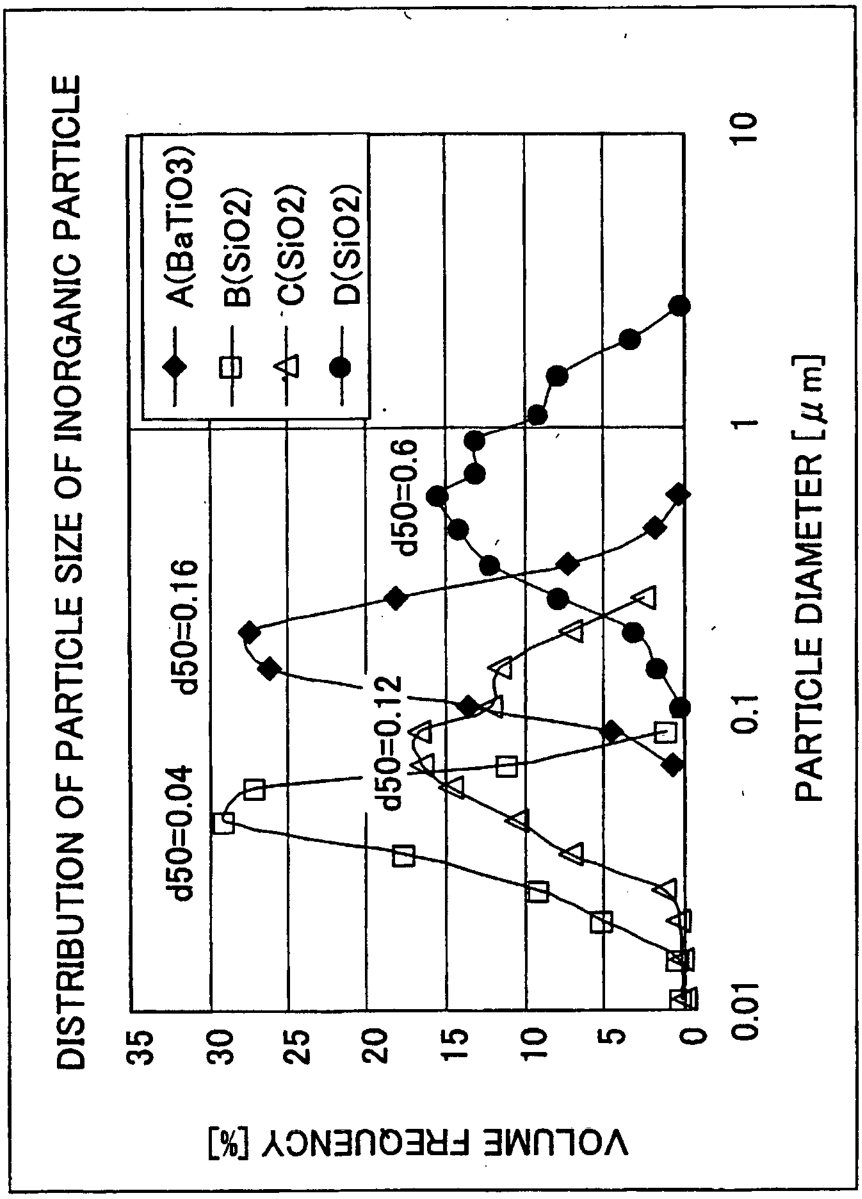
DISTRIBUTION OF PARTICLE SIZE OF INORGANIC PARTICLE
VOLUME FREQUENCY [%]
35
30
25
20
15
10
5
0
0.01
0.1
1
10
PARTICLE DIAMETER [μm]
A(BaTiO3)
B(SiO2)
C(SiO2)
D(SiO2)
d50=0.04
d50=0.16
d50=0.12
d50=0.6

FIG.3

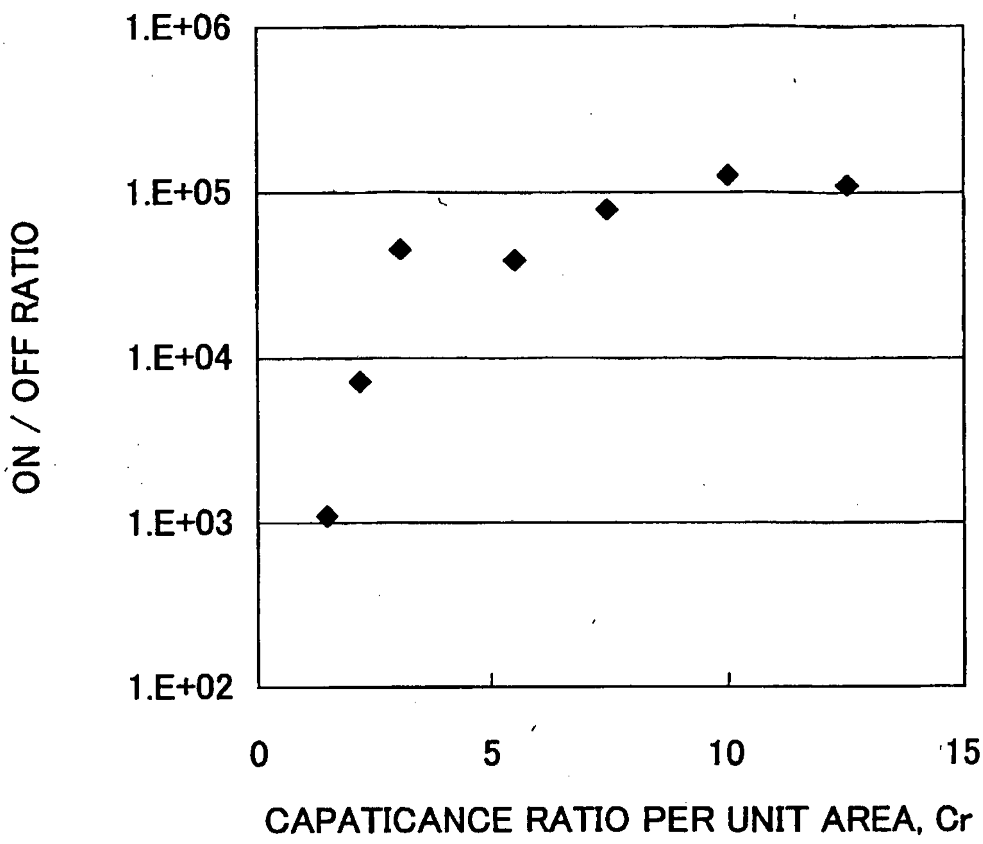
1.E+06
1.E+05
1.E+04
1.E+03
1.E+02
ON / OFF RATIO
0
5
10
15
CAPATICANCE RATIO PER UNIT AREA, Cr

FIG.4

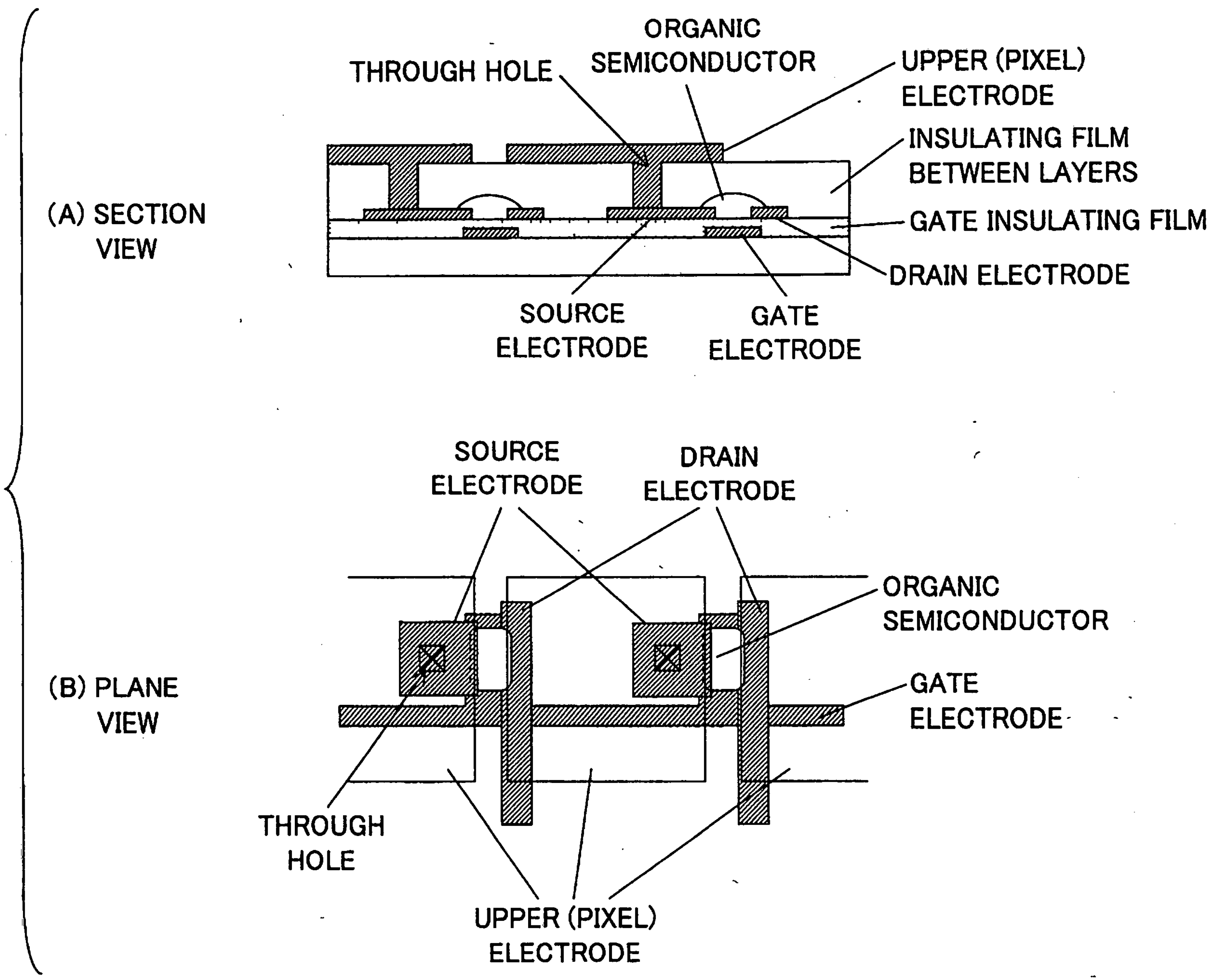
(A) SECTION VIEW
THROUGH HOLE
ORGANIC SEMICONDUCTOR
UPPER (PIXEL) ELECTRODE
INSULATING FILM BETWEEN LAYERS
GATE INSULATING FILM
DRAIN ELECTRODE
SOURCE ELECTRODE
GATE ELECTRODE
(B) PLANE VIEW
SOURCE ELECTRODE
DRAIN ELECTRODE
ORGANIC SEMICONDUCTOR
GATE ELECTRODE
THROUGH HOLE
UPPER (PIXEL) ELECTRODE

FIG.5

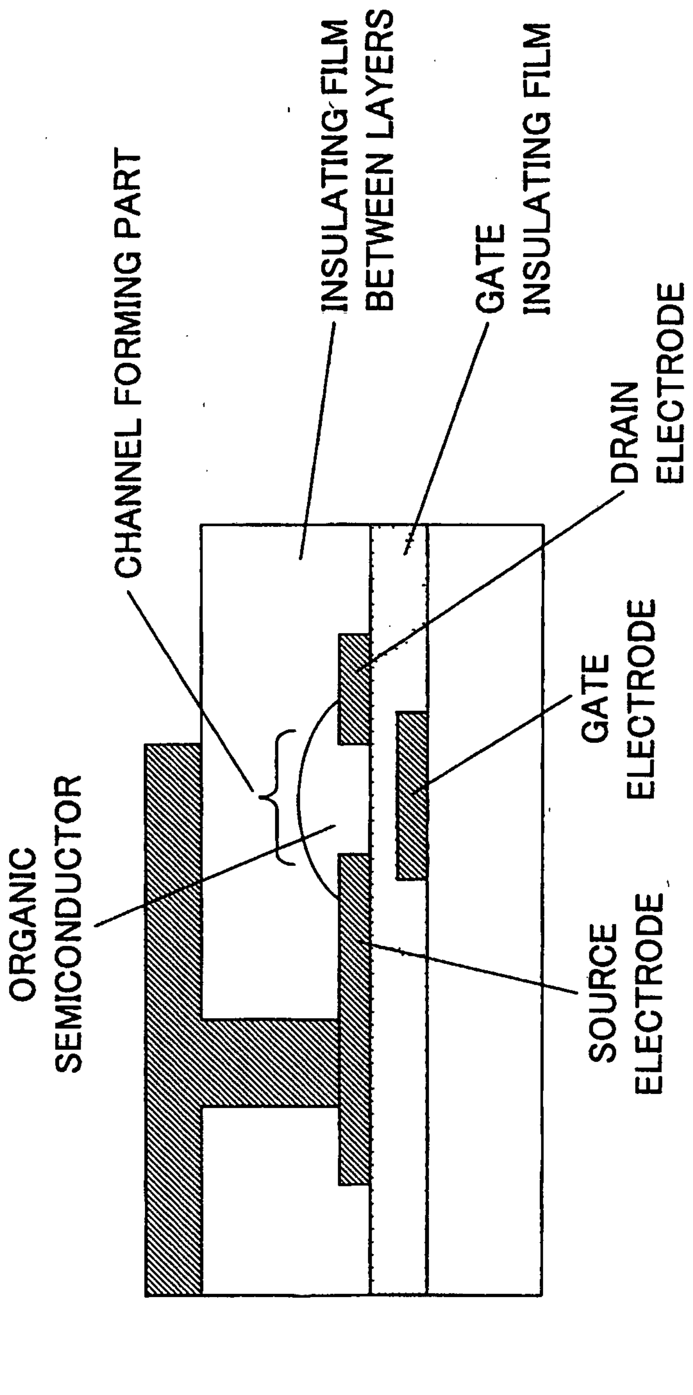
CHANNEL FORMING PART
INSULATING FILM BETWEEN LAYERS
GATE INSULATING FILM
DRAIN ELECTRODE
GATE ELECTRODE
SOURCE ELECTRODE
ORGANIC SEMICONDUCTOR

FIG.6

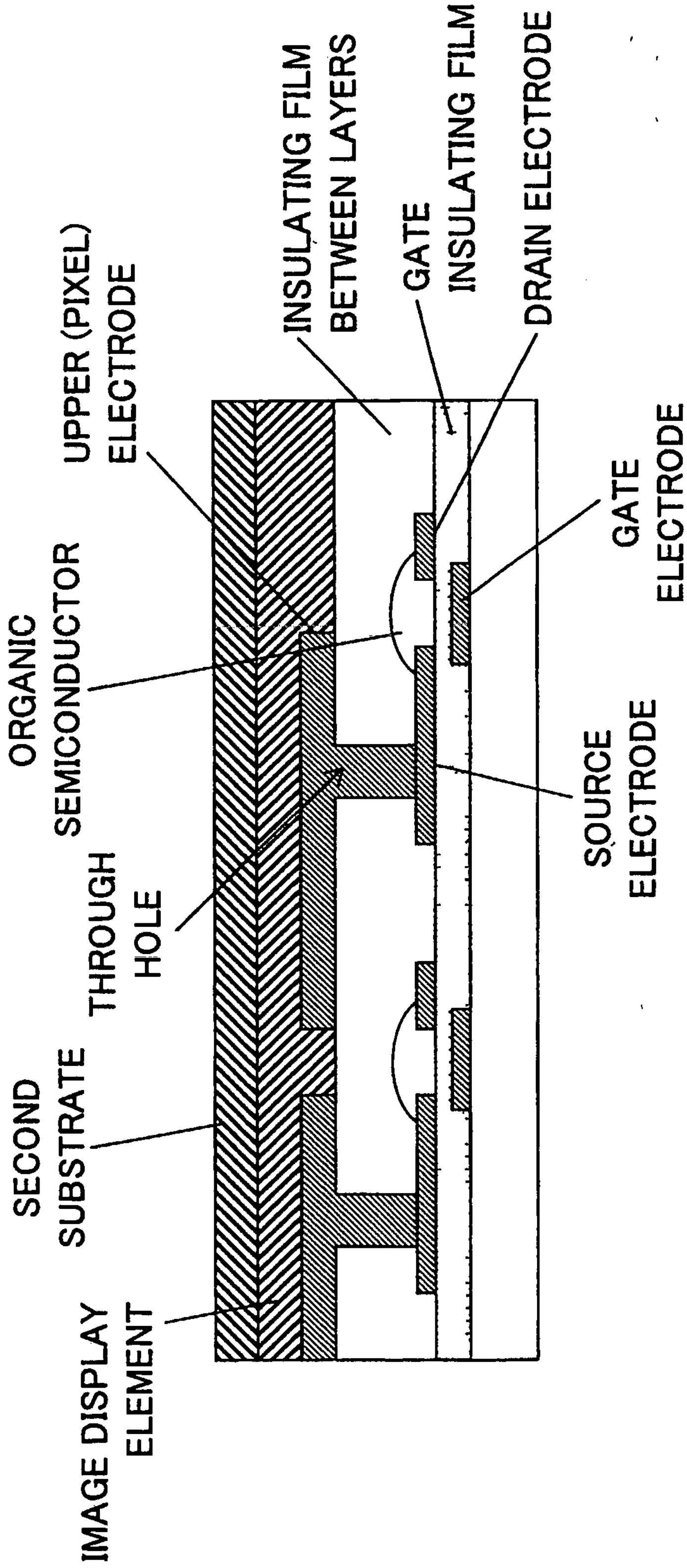
UPPER (PIXEL) ELECTRODE
INSULATING FILM BETWEEN LAYERS
GATE INSULATING FILM
DRAIN ELECTRODE
ORGANIC SEMICONDUCTOR
GATE ELECTRODE
THROUGH HOLE
SOURCE ELECTRODE
SECOND SUBSTRATE
IMAGE DISPLAY ELEMENT

FIG.7

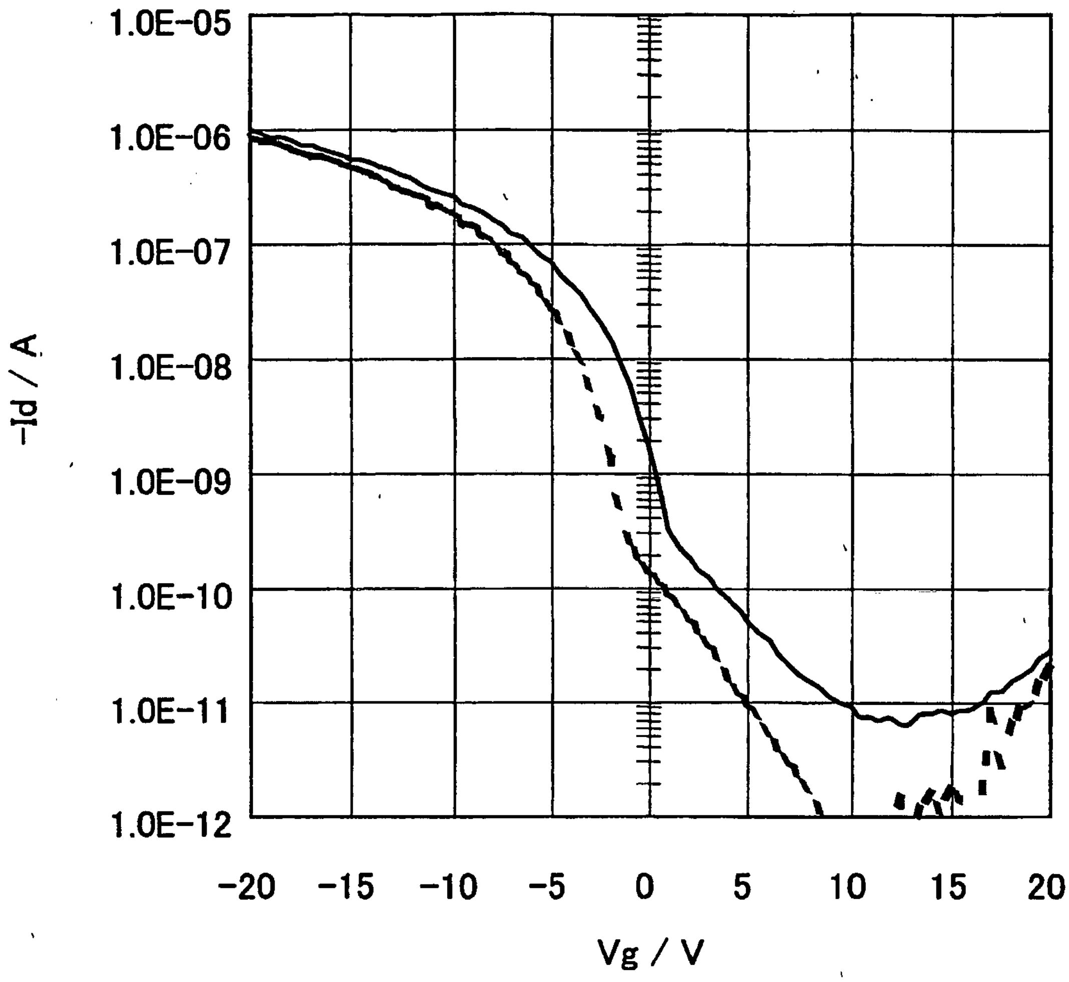


SOLID LINE : THE UPPER ELECTRODE IS −20V
DOTTED LINE : THE UPPER ELECTRODE IS 0V

FIG.8

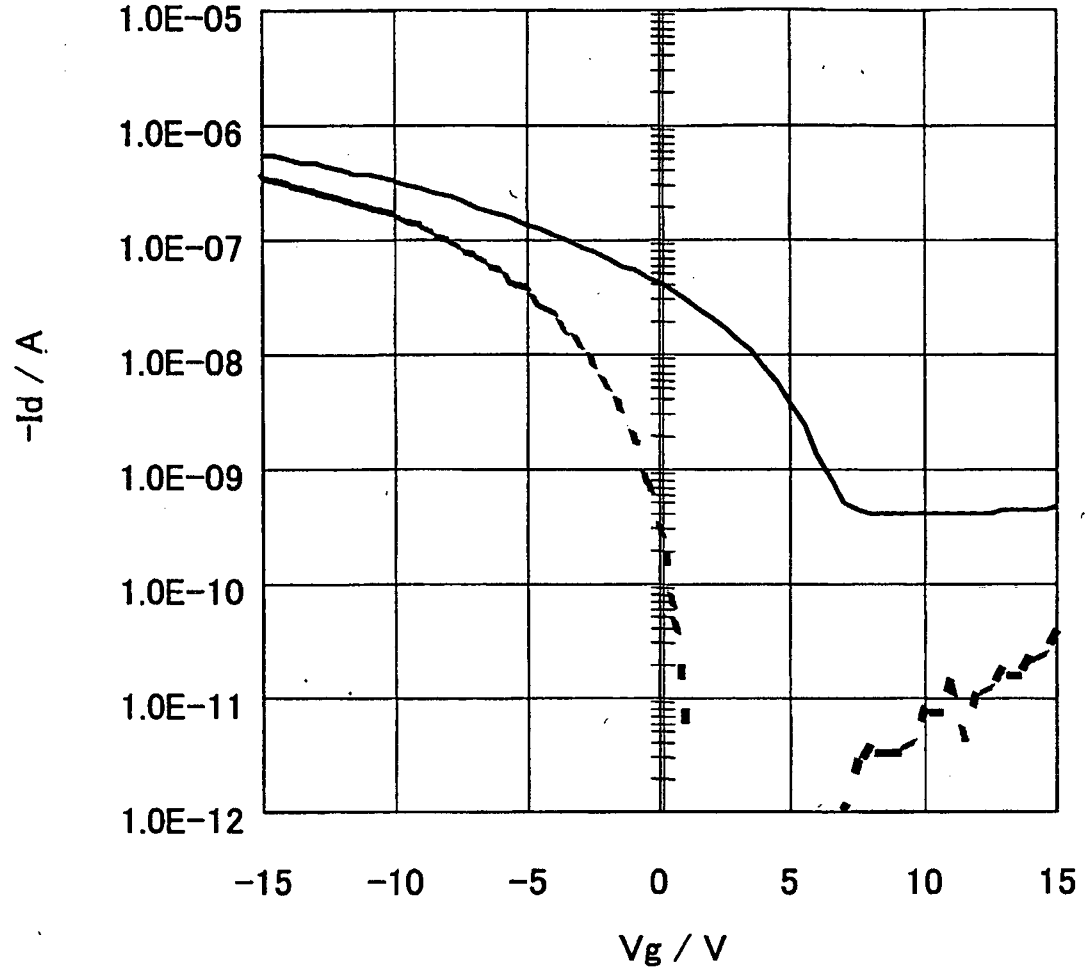


SOLID LINE : THE UPPER ELECTRODE IS −10V
DOTTED LINE : THE UPPER ELECTRODE IS 0V

FIG.9

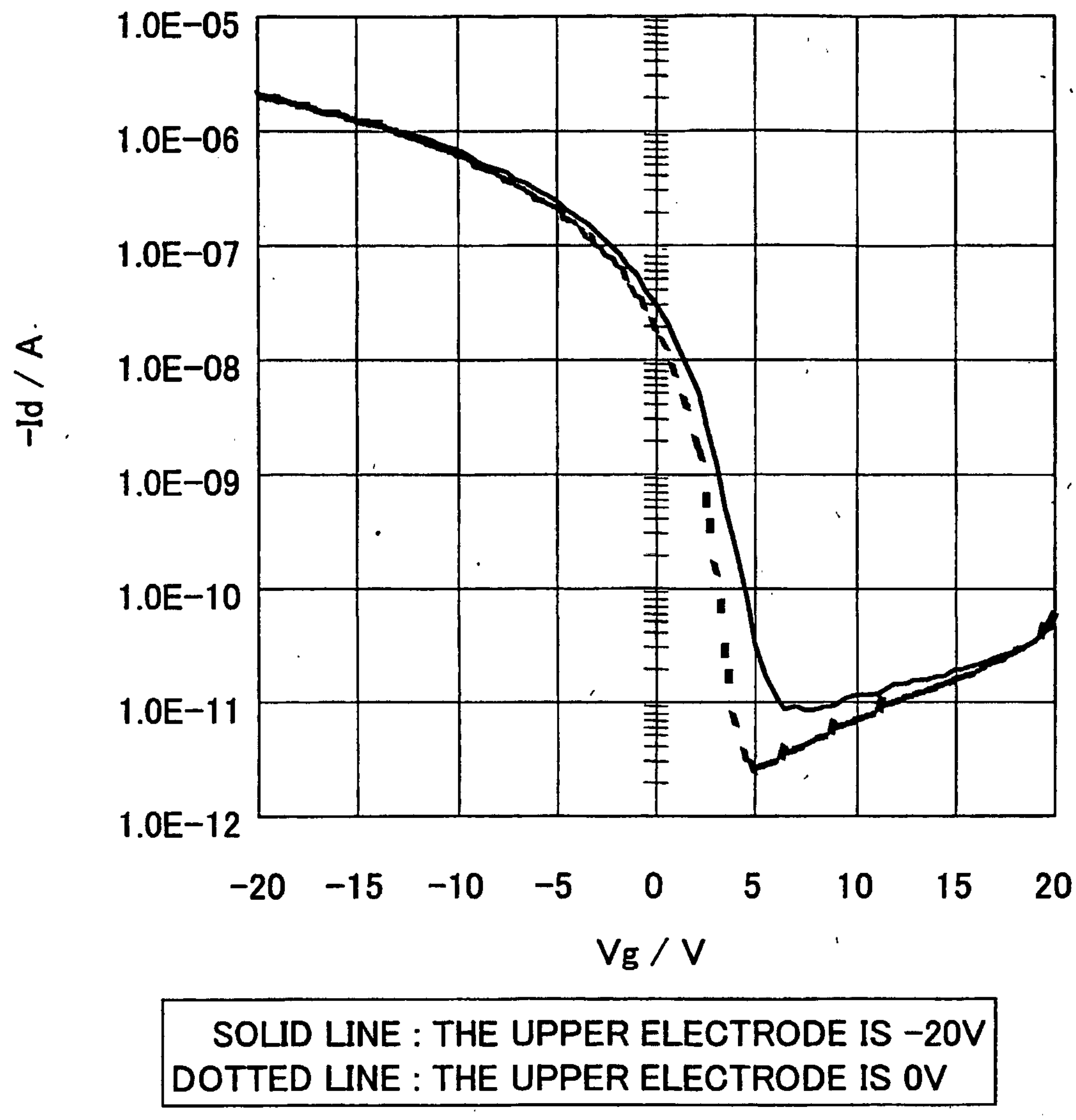
1.0E-05
1.0E-06
1.0E-07
1.0E-08
1.0E-09
1.0E-10
1.0E-11
1.0E-12
-Id / A
-20
-15
-10
-5
0
5
10
15
20
Vg / V
SOLID LINE : THE UPPER ELECTRODE IS -20V
DOTTED LINE : THE UPPER ELECTRODE IS 0V

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005101555 A
- JP 2004247434 A
- JP 2005079549 A
- JP 2004126557 A
- JP 2005223049 A
- DE 10340641 A1
- US 2003067458 A1
- US 6618029 B1


### Non-patent literature cited in the description


- **G.H. GELINCK ; H.E. HUITEMA ; M. VAN MIL ; E. VAN VEENENDAAL ; P.J.G. VAN LIESHOUT ; F.J. TOUWSLAGER.** SID 05 DIGEST 3.1: Invited Paper: Rollable QVGA Active-Matrix Displays Based on Organic Electronics. *Polymer Vision/Philips Research Laboratories, Eindhoven, The Netherlands*
- **J. WANG ; D.J. GUNDLACH ; C.C. KUO ; T.N. JACKSON.** *41st Electronic Materials Conference Digest,* June 1999, 16
- **J.E. ANTHONYRA et al.** *Org. Lett.,* 2002, vol. 4, 15
- **P.T. HERWIG et al.** *Adv. Mater.,* 1999, vol. 11, 480